# EUROPEAN PATENT SPECIFICATION

(11) **EP 4 294 137 B1**
(45) Date of publication and mention of the grant of the patent: **12.11.2025**
(21) Application number: 22771818.6
(22) Date of filing: 18.03.2022
(51) Int. Cl.: H05K 5/06, H05K 5/04, H04M 1/02, B22D 17/00, H04M 1/18, H04M 1/21, H04B 1/3827, H04B 1/525

(54) **PORTABLE ELECTRONIC DEVICE AND METHOD FOR MANUFACTURING SAME**
TRAGBARE ELEKTRONISCHE VORRICHTUNG UND VERFAHREN ZUR HERSTELLUNG DAVON
DISPOSITIF ÉLECTRONIQUE PORTABLE ET SON PROCÉDÉ DE FABRICATION

(30) Priority: 18.03.2021 KR 20210035133
(43) Date of publication of application: 20.12.2023
(73) Proprietor: Samsung Electronics Co., Ltd., Suwon-si, Gyeonggi-do 16677 (KR)
(72) Inventor: BAEK, Seungchang, Suwon-si, Gyeonggi-do 16677 (KR); SON, Hyeongsam, Suwon-si, Gyeonggi-do 16677 (KR); SHIN, Changhyeok, Suwon-si, Gyeonggi-do 16677 (KR); IM, Junghyun, Suwon-si, Gyeonggi-do 16677 (KR); PARK, Jinwoo, Suwon-si, Gyeonggi-do 16677 (KR); JEONG, Jinhwan, Suwon-si, Gyeonggi-do 16677 (KR); CHO, Sungho, Suwon-si, Gyeonggi-do 16677 (KR); YOO, Minwoo, Suwon-si, Gyeonggi-do 16677 (KR)
(74) Representative: Gulde & Partner
(86) International application number: PCT/KR2022/003836
(87) International publication number: WO 2022/197152

(56) References cited:
- JP-A- 2014 011 742
- JP-A- 2014 011 742
- KR-A- 20150 084 209
- KR-A- 20150 084 209
- KR-A- 20150 105 143
- KR-A- 20170 033 633
- KR-A- 20190 054 384
- KR-A- 20190 054 384

## Description

### [TECHNICAL FIELD]

The disclosure relates to a mobile electronic device that has a waterproof function, and a method of manufacturing the same.

### [BACKGROUND ART]

A mobile electronic device includes a housing, an outer structure of which forms an appearance surface by a single material having a dense tissue, for example, an extruded metal material or a rolled material, and an inner structure of which is manufactured by a computer numerical control (CNC) processing or a press molding. However, the extruded metal material or rolled material has high material and processing costs. The JP 2014 011742 A discloses an electronic device including a back side cabinet with an antenna housing portion has an antenna insertion hole for exposing a stretchable antenna. The antenna housing portion includes a partition wall surrounding the antenna which is integrally molded. The antenna housing portion is sealed by a waterproof tape. The KR 2015 0084209 A discloses an electronic device which includes a speaker device. The KR 2019 0054384 A discloses a process of manufacturing an electronic device including an inner and an outer metal portion, wherein a non-metal portion is coupled to the structure of the outer metal portion and the inner metal portion.

The above information is presented as background information only to assist with an understanding of the disclosure. No determination has been made, and no assertion is made, as to whether any of the above might be applicable as prior art with regard to the disclosure.

### [TECHNICAL PROBLEM]

According to an embodiment, to reduce material and processing costs, a mobile electronic device may form a housing by coupling an inner structure of a casting material, which is inexpensive and easy to process, and an outer structure made of an extruded metal material or a rolled or drawn material, which has an elegant appearance. The housing may include a first space in which accommodates electrical components and a second space in which accommodates other components. In this case, water or dust introduced into the second space from the outside may be introduced into the first space through various paths and cause short circuit of the electrical components arranged in the first space.

Aspects of the disclosure are to address at least the above-mentioned problems and/or disadvantages and to provide at least the advantages described below. Accordingly, an aspect of the disclosure is to provide a mobile electronic device that has low manufacturing costs and excellent waterproof performance.

Additional aspects will be set forth in part in the description which follows and, in part, will be apparent from the description, or may be learned by practice of the presented embodiments.

### [TECHNICAL SOLUTION]

In accordance with the invention, a mobile electronic device is provided according to claim 1.

The second isolation part may be arranged in the second space formed by an internal frame.

The second isolation part may be formed to be bent and extended to a bottom of the second space.

The housing may include an internal frame formed of the metal material to form the first space and the second space and a support frame formed of the injection material to support the internal frame.

The metal material may be a first metal material, and the housing may further include an external frame coupled to the internal frame to form an appearance of the mobile electronic device, and formed of a second metal material different from the first metal material

The first metal material may be a casting material, and the second metal material may include one of an extrusion material, a rolled material, a drawing material, a metal injection molding (MIM) material, a three-dimensional (3D) printing material, or a press material.

The first metal material may include at least one of aluminum (Al), magnesium (Mg), zinc (Zn), copper (Cu) or an alloy thereof, and the second metal material may include at least one of Al, stainless steel (SUS), titanium (Ti), Mg or an alloy thereof.

The injection material may include a thermoplastic resin and an inorganic substance.

The external frame may include a passageway part arranged to connect the second space with the outside of the mobile electronic device.

The support frame may be interposed between the internal frame and the external frame.

The housing may further include a waterproof tape attached between the internal frame and the external frame.

The first component may include a battery, the second component may include an input pen, and the second space may include a pen accommodation part configured to accommodate the input pen.

The second component may include at least one of a side key, a fingerprint recognition key, or a slide camera.

The first isolation part may include pores or cracks, and the pores or cracks of the first isolation part may be filled with the injection material of the second isolation part.

In accordance with the invention, a method of manufacturing a mobile electronic device is provided according to claim 15.

The metal material may be a first metal material, and the method may further include processing an external frame forming an appearance of the mobile electronic device with a second metal material different from the first metal material, and coupling the external frame with the internal frame.

The coupling may include welding or insert-casting the internal frame and the external frame.

The forming of the support frame may include filling pores or cracks of the first isolation part with the injection material of the second isolation part.

The method may further include: performing a surface treatment, which increases a surface area of the first isolation part coupled to the second isolation part.

The die-casting of the internal frame may further include: forming the second space communicating with outside of the mobile electronic device in a first direction and having a side opened in a second direction perpendicular to the first direction; and sealing the opened side of the second space with a sealing member.

### [ADVANTAGEOUS EFFECTS]

As described above, according to the disclosure, the mobile electronic device may form the housing with the inner structure of the casting material, which is inexpensive and easy to process, thereby reducing the material and processing costs.

According to the disclosure, the mobile electronic device may, in the housing including the first space in which accommodates inner components and the second space which is communicated with the outside to accommodate components capable of being taken out, isolate between the first space and the second space with the casting material and the injection material coupled or bonded with each other, thereby preventing water or dust from leaking from the second space to the first space through the pores or cracks of the casting material.

Other aspects, advantages, and salient features of the disclosure will become apparent to those skilled in the art from the following detailed description, which, taken in conjunction with the annexed drawings, discloses various embodiments of the disclosure

### [DESCRIPTION OF DRAWINGS]

The above and other aspects, features, and advantages of certain embodiments of the disclosure will be more apparent from the following description taken in conjunction with the accompanying drawings, in which:
FIG. 1 is a view showing a front surface of a mobile electronic device according to an embodiment of the disclosure.
FIG. 2 is a view showing a rear surface of a mobile electronic device according to an embodiment of the disclosure;
FIG. 3 is an exploded view showing a mobile electronic device according to an embodiment of the disclosure;
FIG. 4 is a view showing a housing of a mobile electronic device according to an embodiment of the disclosure;
FIG. 5 is a view separately showing the housing shown in FIG. 4 according to an embodiment of the disclosure;
FIG. 6 is a picture of photographing an isolation wall from a first space with respect to a portion A of FIG. 5 according to an embodiment of the disclosure;
FIG. 7 is a cross-sectional view taken along line B-B of FIG. 4 according to an embodiment of the disclosure;
FIG. 8 is a cross-sectional view taken along line C-C of FIG. 4 according to an embodiment of the disclosure;
FIG. 9 is a view showing a state in which a first waterproof tape is attached on an outer edge of a first surface of a housing according to an embodiment of the disclosure;
FIG. 10 is a view showing a state in which the first waterproof tape of FIG. 9 is separated according to an embodiment of the disclosure;
FIG. 11 is a view showing a state in which a second waterproof tape is attached on an outer edge of a second surface of a housing according to an embodiment of the disclosure;
FIG. 12 is a view showing a state in which the second waterproof tape of FIG. 11 is separated according to an embodiment of the disclosure;
FIG. 13 is across-sectional view taken along line D-D of FIG. 11 according to an embodiment of the disclosure;
FIG. 14 is a flowchart showing an example of a method of manufacturing a housing of a mobile electronic device according to an embodiment of the disclosure;
FIG. 15 is a view showing a process of manufacturing the housing of FIG. 14 according to an embodiment of the disclosure;
FIG. 16 is a flowchart showing another example of a method of manufacturing a housing of a mobile electronic device according to an embodiment of the disclosure;
FIG. 17 is a view showing a process of manufacturing the housing of FIG. 16 according to an embodiment of the disclosure;
FIG. 18 is a view showing a housing according to an embodiment of the disclosure;
FIG. 19 is a cross-sectional view taken along line E-E of FIG. 18 according to an embodiment of the disclosure.
FIG. 20 is a view showing a housing according to an embodiment of the disclosure;
FIG. 21 is a cross-sectional view taken along line F-F of FIG. 20 according to an embodiment of the disclosure.
FIG. 22 is a view showing a housing according to an embodiment of the disclosure;
FIG. 23 is a cross-sectional view taken along line G-G of FIG. 22 according to an embodiment of the disclosure;
FIG. 24 is a view showing a housing according to an embodiment of the disclosure;
FIG. 25 is a cross-sectional view taken along line H-H of FIG. 24 according to an embodiment of the disclosure; and
FIG. 26 is a block diagram of an electronic device in a network environment according to an embodiment of the disclosure.

Throughout the drawings, it should be noted that like reference numbers are used to depict the same or similar elements, features, and structures.

### [BEST MODE]

The following description with reference to the accompanying drawings is provided to assist in a comprehensive understanding of various embodiments of the disclosure as defined by the claims and their equivalents. It includes various specific details to assist in that understanding but these are to be regarded as merely exemplary. In addition, description well-known functions and constructions may be omitted for clarity and conciseness.

The terms and words used in the following description and claims are not limited to the bibliographical meanings, but, are merely used by the inventor to enable a clear and consistent understanding of the disclosure. Accordingly, it should be apparent to those skilled in the art that the following description of various embodiments of the disclosure is provided for illustration purpose only and not for the purpose of limiting the disclosure as defined by the appended claims.

It is to be understood that the singular forms "a," "an," and "the" include plural referents unless the context clearly dictates otherwise. Thus, for example, reference to "a component surface" includes reference to one or more of such surfaces. In the disclosure, terms "have", "may have", "include", "may include", etc. indicate the presence of corresponding features (e.g., a numeral value, a function, an operation, or an element such as a part, etc.), and do not exclude the presence of additional features.

In the disclosure, terms "A or B", "at least one of A or/and B", "one or more of A or/and B" or the like may include all possible combinations of elements enumerated together. For example, "A or B", "at least one of A and B", or "at least one of A or B" may refer to all of the cases of (1) including at least one A, (2) including at least one B, or (3) including all of at least one A and at least one B.

In addition, in the disclosure, terms "upper", "lower", "left", "right", "inside", "outside", "inner", "outer", "front", "rear", etc. are defined with respect to the accompanying drawings, and do not restrict the shape or location of the elements.

Further, in the disclosure, the expression of "configured to (or set to)" may for example be replaced with "suitable for," "having the capacity to," "designed to," "adapted to," "made to," or "capable of" according to circumstances. Also, the expression of "configured to (or set to)" may not necessarily refer to only "specifically designed to" in terms of hardware. Instead, the "device configured to" may refer to "capable of" along with other devices or parts in a certain circumstance.

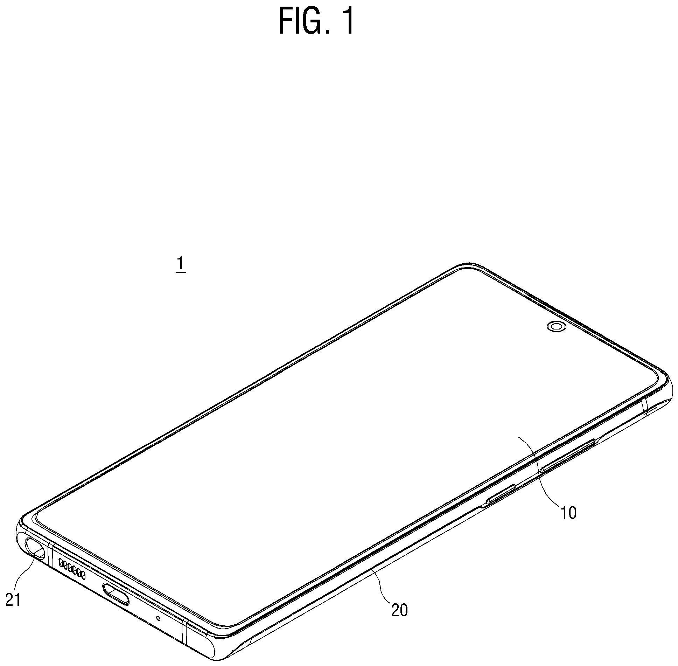

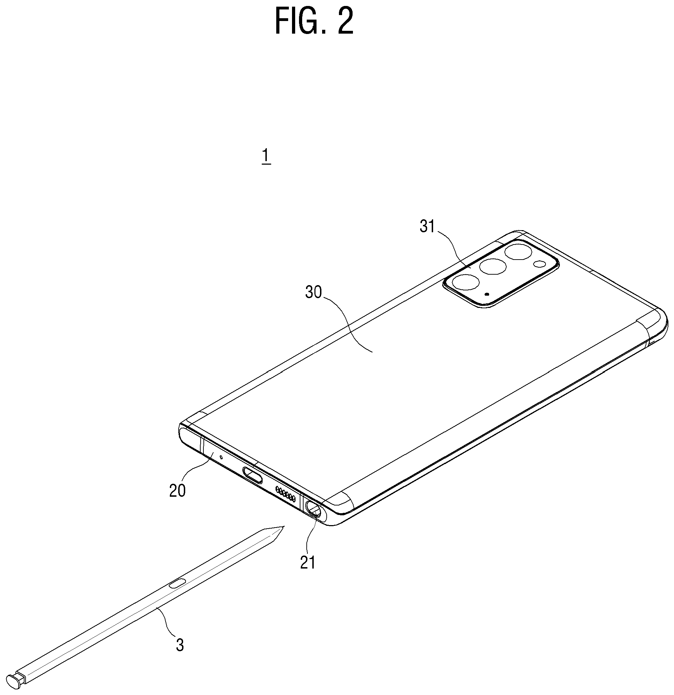

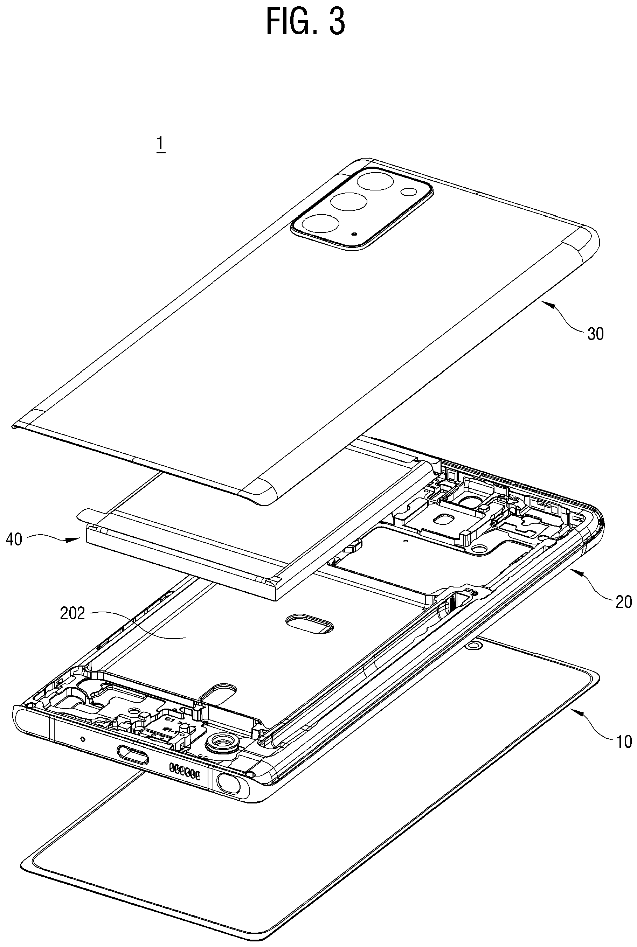

FIG. 1 is a view showing a front surface of an electronic device 1 according to an embodiment of the disclosure, FIG. 2 is a view showing a rear surface of the electronic device 1 according to an embodiment of the disclosure, and FIG. 3 is an exploded view showing the electronic device 1 of FIG. 2 according to an embodiment of the disclosure.

According to an embodiment of the disclosure, the electronic device 1 may be, for example, a user mobile device such as a smart phone, a tablet device, or a smart note. The electronic device 1 may have a rectangular parallelepiped shape having a predetermined volume or a shape similar thereto. For example, the front and rear surfaces of the electronic device 1 are implemented in flat planes, but all or some (e.g., two left/right side surfaces)of four side surfaces of the electronic device 1 may be implemented to have any curvature to improve grip feeling.

Referring to FIGS. 1 to 3, the electronic device 1 may include a cover window 10, a housing 20, a rear cover 30, an input pen 3, and a passageway part 21.

The cover window 10 may form a front appearance of the electronic device 1. The cover window 10 may cover components, for example, a display module or the like arranged on a first surface of the housing 20, from the front of the electronic device 1. The cover window 10 may be bent on one surface of the electronic device 1. For example, the cover window 10 may be bent at edges of both side ends of the electronic device1.

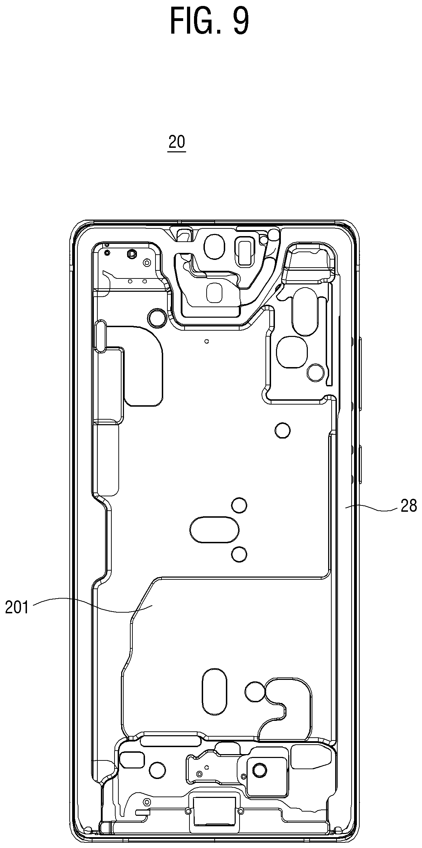

The housing 20 accommodates and support components, e.g., a display module, etc. of the electronic device 1on the first surface (reference numeral 201 in FIG. 9) thereof facing the cover window 10.

The housing 20 may accommodate and support a battery 40, a camera module, a printed circuit board and the like on a second surface 202 thereof facing the rear cover 30.

A detailed structure of the housing 20 will be described later.

The rear cover 30 may form a rear appearance of the electronic device 1. The rear cover 30 may cover components accommodated in the housing 20 from the rear of the electronic device 1. The rear cover 30 may be bent at edges of the both side ends of the electronic device 1. The rear cover 30 may include a camera area 31 arranged to expose at least one rear camera lens.

The electronic device 1 may further include a side cover arranged to form an appearance of a side surface portion thereof.

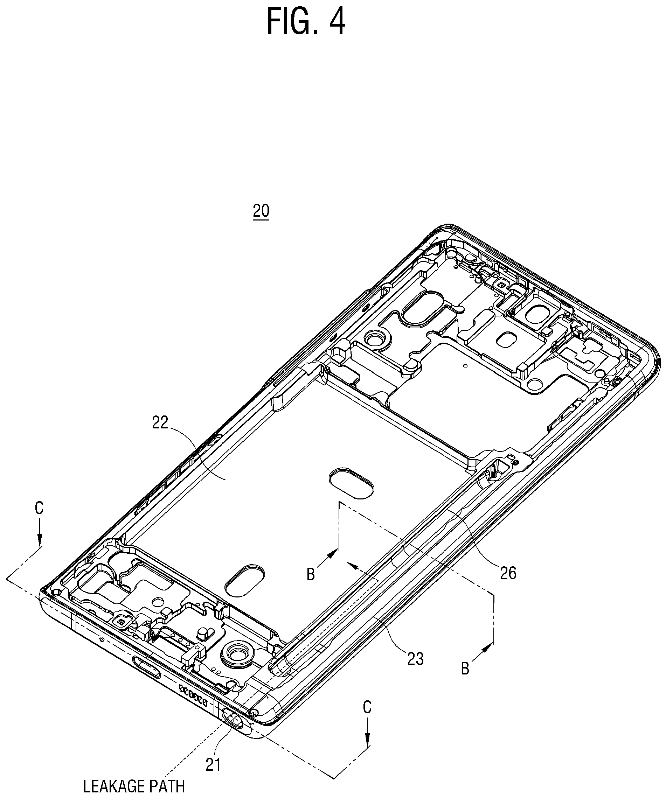

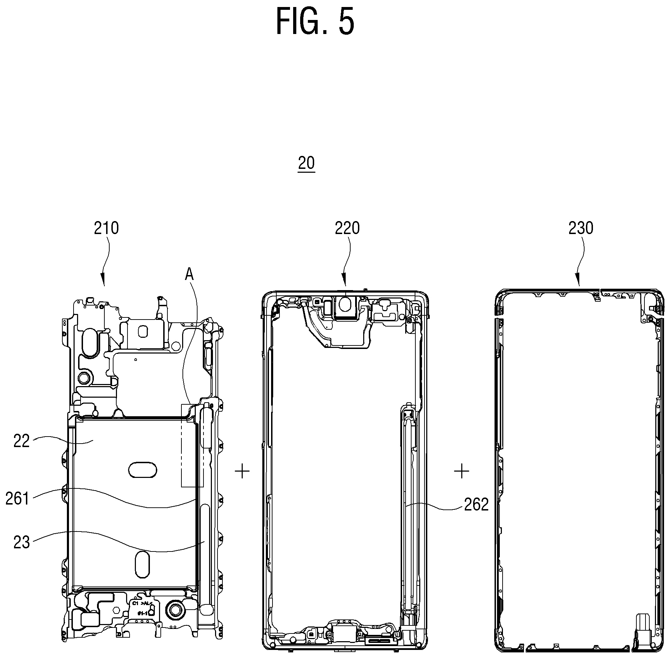

FIG. 4 is a view showing the housing 20 according to an embodiment of the disclosure, and FIG. 5 is a view separately showing the housing 20 of FIG. 4 according to an embodiment of the disclosure.

Referring to FIG. 4, the housing 20 includes a first space 22 and a second space 23 adjacent to the first space 22. The housing 20 may include a passageway part 21, for example, a pen insertion inlet, which connects the second space 23 to the outside.

A battery (reference numeral 40 in FIG. 3) may be accommodated in the first space 22.

The second space 23 may include a pen receiving part in which an input pen (reference numeral 3 in FIG. 2) may be inserted through the passageway part 21 from the outside is stored. The input pen 3 is removable from the housing 20.

The first space 22 and the second space 23 are isolated by an isolation wall 26.

Referring to FIG. 5, the housing 20 may include an internal frame 210 of a casting material that forms an inside of the electronic device 1, an external frame 230 of a rolled or extruded material that is coupled with the internal frame 210 to form the appearance of the electronic device 1, and a support frame 220 of an injection material that supports the internal frame 210 and the external frame 230 coupled with each other. A method of manufacturing the housing 20 will be described in detail later.

The internal frame 210 may form an inner structure of the housing 20 and provide mechanical strength capable of supporting components of the electronic device 1.

The internal frame 210 may include a first isolation wall 261 of a casting material that isolates between the first space 22 and the second space23.

The internal frame 210 may be formed of a casting metal material.

The casting material may include, for example, at least one of aluminum (Al), magnesium (Mg), zinc (Zn), copper (Cu) or an alloy thereof. The casting material may contain, for example, 2% or more of a Si component in the case of an Al casting alloy. The casting material may contain, for example, 5% or more of an Al component in the case of an Mg casting alloy.

The casting material is cheaper than the rolled or extrusion material and is easy to cast.

The support frame 220 may support the internal frame 210 and the external frame 230 and may form the housing 20 together with the internal frame 210 and the external frame 230.

The support frame 220 may include a second isolation wall 262 of an injection material that is coupled or bonded to the second space 23 of the internal frame 210.

The support frame 220 may be formed of an injection material.

The injection material may include various materials such as polycarbonate (PC) and polyphthalamide (PPA). According to an embodiment, the injection material may include a non-conductive thermoplastic resin such as, for example, PC, polybutylene terephthalate (PBT), polyphenylene sulfide (PPS), polyamide (PA), PPA, polyethylene terephthalate (PET), polyetheretheketone (PEEK), polyaryletherketone (PAEK), polyphenylsulfone (PPSU) and the like, and an inorganic substance such as, for example, glass fibers (GF), carbon fiber (CF), Talc and the like.

The injection material may include, for example, a non-metal material such as a polymer-based PC GF 10% (polycarbonate reinforced with 10% glass fibers).

The external frame 230 may form an appearance of the housing 20. The external frame 230 may be formed by at least one of rolled material, extrusion material, drawing material, metal injection molding (MIM) material, three dimensional (3D) printing material, or press metal material, for example, Al, stainless steel (SUS), titanium (Ti), Mg or an alloy thereof.

The external frame 230 may be coupled to the internal frame 210 by welding or insert casting. For elegant appearance, the external frame 230 may be surface-treated by, for example, anodizing, physical vapor deposition (PVD), electrodeposition, coating, micro arc oxidation (MAO), plasma electrolyzed coating (PEO) or the like.

The external frame 230 may be insert-injected into the support frame 220 while being coupled to the internal frame 210.

According to an embodiment, the external frame 230 may further include an antenna radiator or the like.

According to an embodiment, the external frame 230 may be omitted and replaced with a support frame of an injection material.

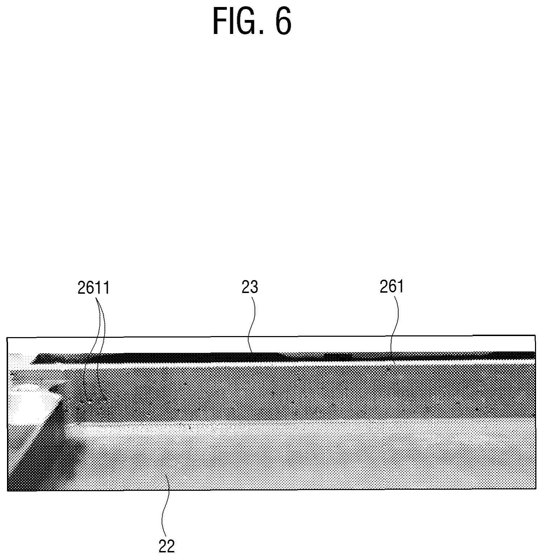

FIG. 6 is a picture of photographing the isolation wall 26 from the first space 22 with respect to a portion A of FIG. 5 according to an embodiment of the disclosure.

Referring to FIG. 6, when the internal frame 210 of FIG. 5 is formed, the first isolation wall 261 made of the casting material for isolating between the first space 22 and the second space23 may have pores 2611 resulting from casting molding shrinkage. In this case, the pores 2611 may be formed in a size of about 0.01 to 15 mm depending on the casting state. In particular, there is a possibility that the pores 2611 may be connected in a process that the first isolation wall 261 of the casting material is thinned after being casting-molded.

Since the second space23 communicates with the outside through the passageway part 21, water or dust may be introduced therein. Therefore, the electronic device 1 having a waterproof function needs to prevent the introduced water or dust from passing through the pores 2611 of the first isolation walls 261 of FIGS. 5 and 6. However, the pores 2611 shown in FIG. 5 are not always generated but may not be generated according to the process or situation, and even if they are generated, they do not always appear in the form shown in FIG. 5. Accordingly, the pores of the disclosure and the description thereof should be understood as being for explanation of the disclosure.

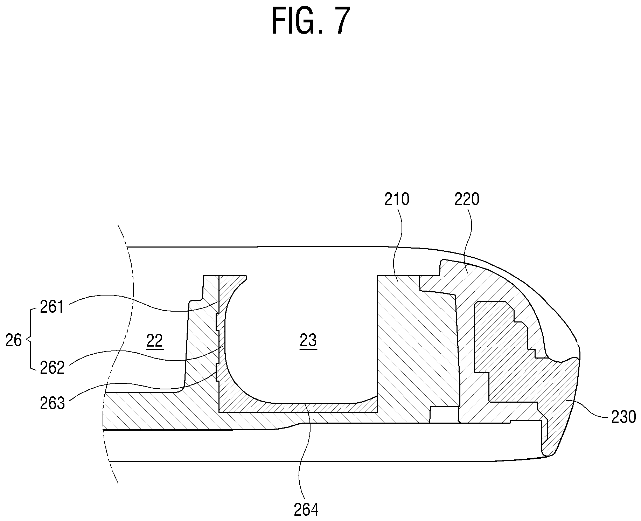

FIG. 7 is a cross-sectional view taken along line B-B of FIG. 4 according to an embodiment of the disclosure.

Referring to FIG. 7, the isolation wall 26 for isolating the first space 22 and the second space23 may include the first isolation wall 261 of the casting material and the second isolation wall 262 of the injection material coupled or bonded by insert injection of the support frame 220 including the internal frame 210.

The first isolation wall 261 may be formed by casting the internal frame 210 alone or by insert-casting the internal frame 210 with the external frame 230.

The second isolation wall 262 may be formed by insert-injecting the support frame 220 with the injection material.

During the insert injection, the second isolation wall 262 made of the injection material may be coupled or bonded to the first isolation wall 261 of the casting material to prevent water introduced into the second space 23 from passing through the first space 22.

In order to increase bonding force or adhesion between the casting material of the first isolation wall 261 and the injection material of the second isolation wall 262, the first isolation wall 261 may, for example, forma uneven part 263 or be subjected to roughness surface treatment for increasing contact area thereon.

The second isolation wall 262 may include an extension part 264 that is bent and extended to a bottom of the second space 23. At least one of the second isolation wall 262 or the extension part 264 may be formed to accommodate a shape of the input pen 3.

According to an embodiment, a chemical bonding treatment layer such as a thin bonding film or the like may be included between the first isolation wall 261 and the second isolation wall 262.

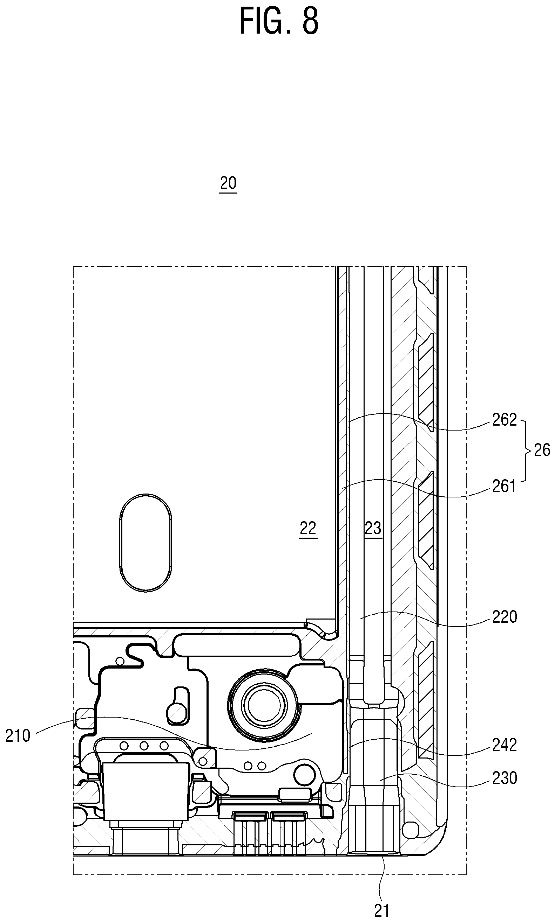

FIG. 8 is a cross-sectional view taken along line C-C of FIG. 4 according to an embodiment of the disclosure.

Referring to FIG. 8, the external frame 230 may include the passageway part 21 communicating with the second space 23. The passageway part 21 may be coupled in the second space 23 when the internal frame 210 and the external frame 230 are coupled. In this case, the second isolation wall 262 of the injection material arranged in the second space 23 may block between an inside end of the passageway part 21 and the first isolation wall 261 of the internal frame 210. Additionally, the second isolation wall 262 of the injection material may extend and fill a gap 242 between the first isolation wall 261 on the second space23 and an outside surface of the passageway part 21.

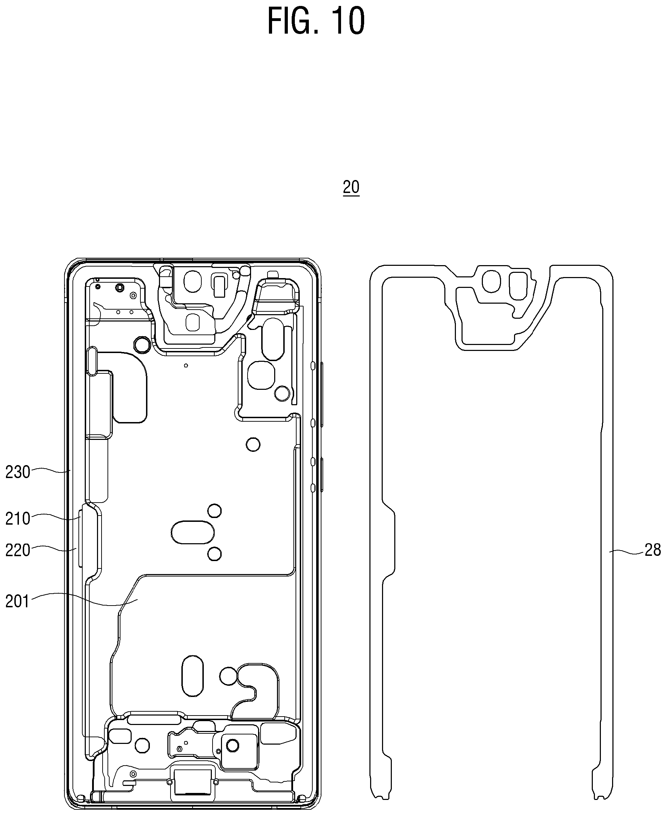

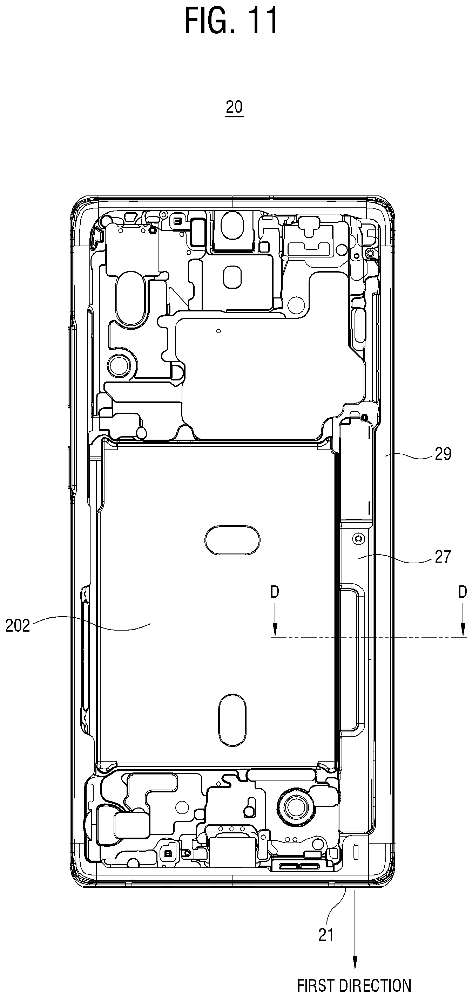

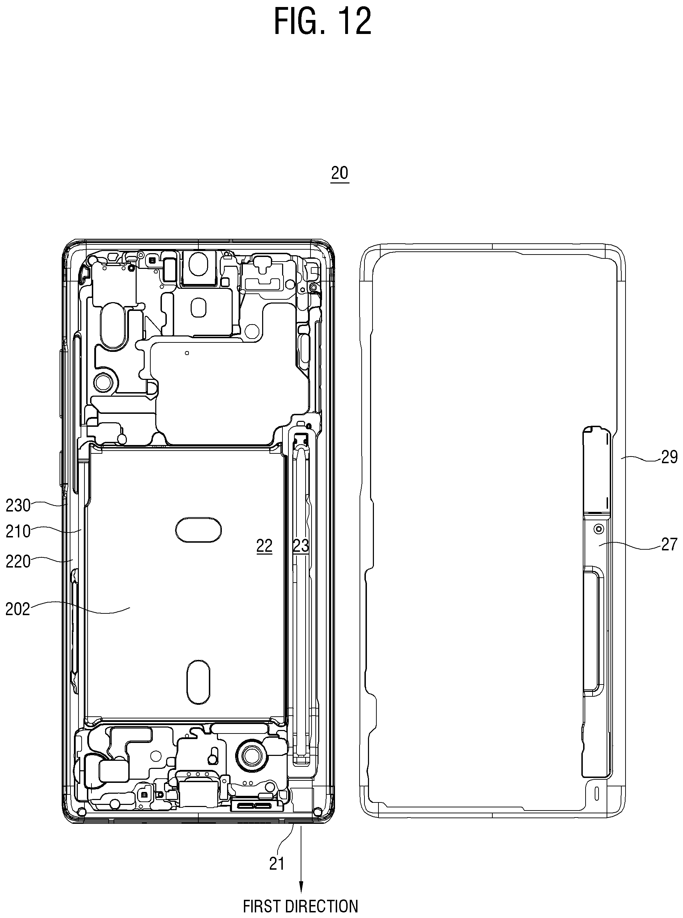

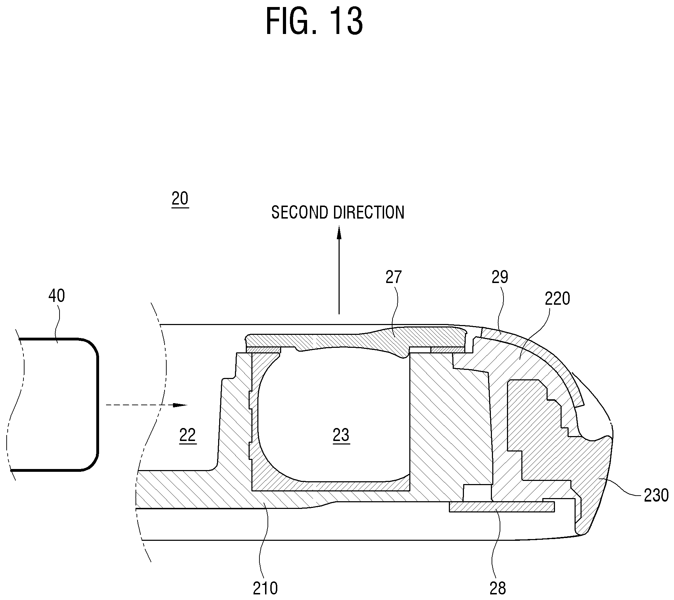

FIG. 9 is a view showing a state in which a first waterproof tape 28 is attached to an outer edge of a first surface 201 of the housing 20 according to an embodiment of the disclosure, FIG. 10 is a view showing a state in which the first waterproof tape 28 of FIG. 9 is separated according to an embodiment of the disclosure, FIG. 11 is a view showing a state in which a second waterproof tape 29 is attached on an outer edge of a second surface 202 of the housing 20 according to an embodiment of the disclosure, FIG. 12 is a view in which the second waterproof tape 29 of FIG. 11 is separated according to an embodiment of the disclosure, and FIG. 13 is across-sectional view taken along line D-D of FIG. 11 according to an embodiment of the disclosure.

A boundary portion between the internal frame 210 and the external frame 230 at the outer edge of the first surface 201 of the housing 20 may be a path through which external water leaks. Accordingly, the inside of the boundary portion between the internal frame 210 and the external frame 230 may be filled with an injection material during insert injection of the support frame 220 in the same manner as shown in FIG. 8, and the outside of the boundary portion may be attached with the first waterproof tape 28 as shown in FIGS. 9 and 13, thereby blocking the leakage of water.

Likewise, the outside of the boundary portion between the internal frame 210 and the external frame 230 at the outer edge of the second surface 202 of the housing 20 may be attached with the second waterproof tape 29 as shown in FIGS. 11 and 13 to block the leakage of water.

According to an embodiment, the first and second waterproof tapes 28 and 29 may be also attached between the internal frame 210 and the support frame 220 or outside the boundary portion between the support frame 220 and the external frame 230.

Referring to FIGS. 12 and 13, when the housing 20 is manufactured, one side of the second space 23 in a second direction perpendicular to a first direction toward the passageway part 21, which is a passage communicating with the outside, may be opened. Since water introduced into the second space 23 may leak to the first space 22 through the opened one side of the second space 23, a sealing member 27 may be arranged on the opened one side. The sealing member 27 may be made of, for example, silicon or rubber having elasticity and waterproof performance.

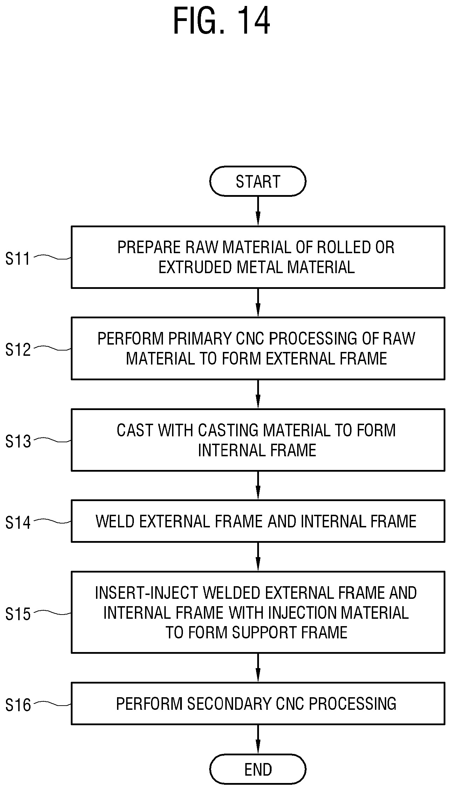

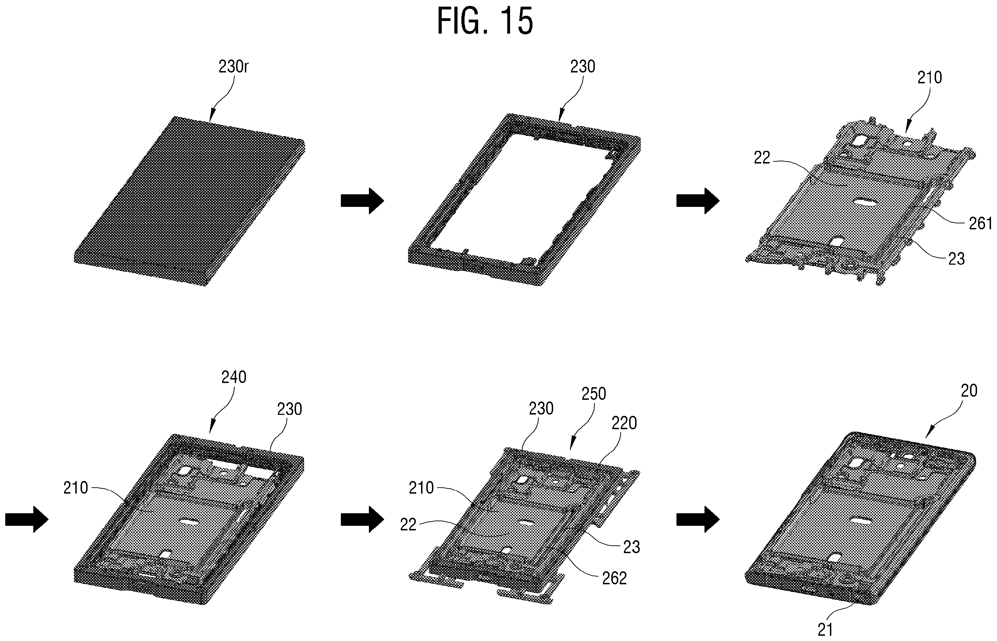

FIG. 14 is a flowchart showing an example of a method of manufacturing the housing 20 of the electronic device 1 according to an embodiment of the disclosure, and FIG. 15 is a view showing a process of manufacturing the housing 20 of FIG. 14 according to an embodiment of the disclosure.

Hereinafter, the method of manufacturing the housing 20 according to an embodiment will be described with reference to FIGS. 14 and 15.

Referring to FIGS. 14 and 15, at operation S11, a raw material 230r made of a rolled or extruded metal material may be prepared. The raw material 230r may have a block shape or a frame shape. The extruded or rolled material may include, for example, at least one of Al, SUS, Ti, Mg, or an alloy thereof.

At operation S12, an external frame 230 may be formed by primary CNC processing, drawing, pressing, MIM, or 3D printing of the raw material 230r. To provide an elegant appearance, the external frame 230 may be surface-treated by a method, such as anodizing, PVD, electrodeposition, painting, MAO, PEO or the like.

At operation S13, an internal frame 210 may be formed by casting with a casting material. In this case, the internal frame 210 may be formed to include a first space 22, a second space 23, and a first isolation wall 261 for isolating between the first space 22 and the second space 23.

The casting material may include, for example, at least one of Al, Mg, Zn, or an alloy thereof. The casting material may contain, for example, 2% or more of a Si component in the case of an Al casting alloy. The casting material may contain, for example, 5% or more of an Al component in the case of an Mg casting alloy.

At operation S14, a frame assembly 240 may be formed by welding the internal frame 210 in the external frame 230.

At operation S15, an injection frame assembly 250 may be formed by insert injection of an injection material including the frame assembly 240 in which the internal frame 210 and the external frame 230 are coupled to each other. In this case, a support frame 220 of the injection material may support the internal frame 210 and the external frame 230. In addition, the injection material of the support frame 220 is filled in a boundary portion between the internal frame 210 and the external frame 230, and as shown in FIG. 7, a second isolation wall 262 of the injection material may be coupled or bonded to a first isolation wall 261 in a second space 23.

The injection material may include a non-conductive thermoplastic resin, such as PC, PBT, PPS, PA, PPA, PET, PEEK, PAEK, PPSU or the like and an inorganic material, such as GF, CF, Talc or the like. The injection material may include, for example, a non-metal material, such as a polymer-based PC GF 10% (e.g., polycarbonate reinforced with 10% glass fibers).

At operation S16, a housing 20 may be formed by secondary-CNC-processing the injection frame assembly 250. The secondary CNC processing may include a processing process of removing unnecessary portions of the injection frame assembly 250 or forming a passageway part 21 or the like.

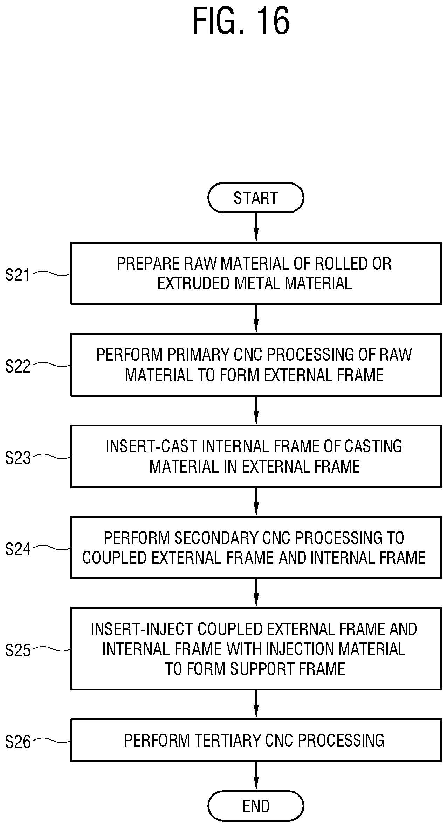

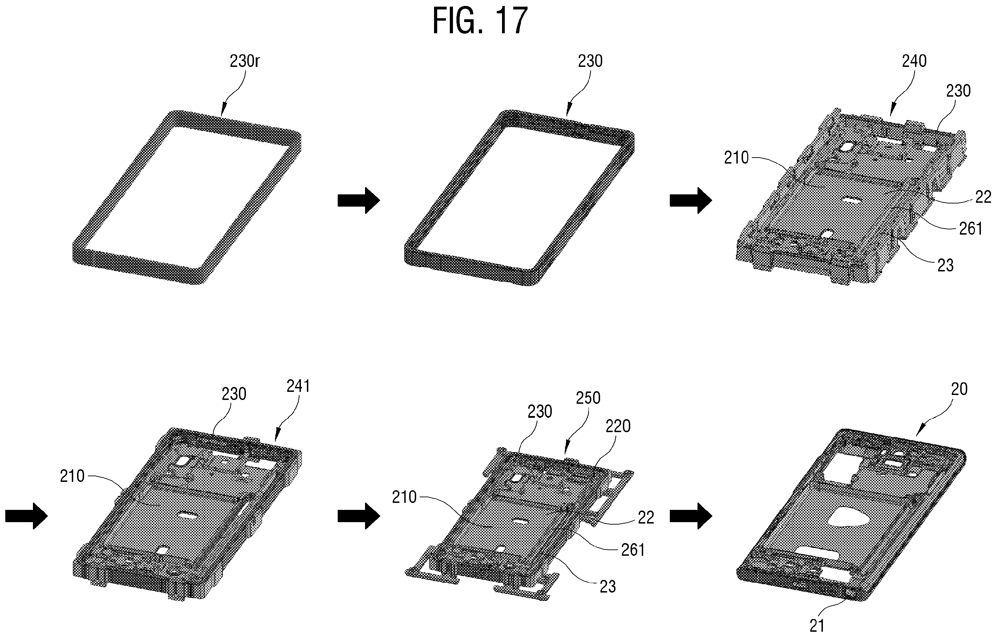

FIG. 16 is a flowchart showing another example of the method of manufacturing the housing 20 of the electronic device 1 according to an embodiment of the disclosure, and FIG. 17 is a view showing a process of manufacturing the housing 20 of FIG. 16 according to an embodiment of the disclosure.

Hereinafter, the method of manufacturing the housing 20 according to an embodiment will be described with reference to FIGS. 16 and 17.

Referring to FIGS. 16 and 17, at operation S21, a raw material 230r made of a rolled or extruded metal material may be prepared. The raw material 230r may have a frame shape or a block shape.

At operation S22, the raw material 230r may be primarily CNC-processed to form an external frame 230. To provide an elegant appearance, the external frame 230 may be surface-treated by a method such as anodizing, PVD, electrodeposition, painting, MAO, or PEO.

At operation S23, the external frame 230 may be insert-casted with a casting material to form a frame assembly 240 in which an internal frame 210 and the external frame 230 are coupled. In this case, a first space22,a second space23, and a first isolation wall 261 for isolating between the first space 22 and the second space23 may be formed in the internal frame 210.

At operation S24, a frame processing body 241 may be formed by secondary-CNC-processing the frame assembly 240 in which the internal frame 210 and the external frame 230 are coupled to each other. In this case, the secondary CNC processing may remove unnecessary portions of the frame assembly 240.

At operation S25, an injection frame assembly 250 may be formed by performing insert injection including the frame processing body 241 with an injection material. In this case, a support frame 220 of the injection material may support the internal frame 210 and the external frame 230. In addition, the injection material of the support frame 220 may be filled in a boundary portion between the internal frame 210 and the external frame 230, and as shown in FIG. 7, a second isolation wall 262 of the injection material may be bonded to a first isolation wall 261 in a second space 23.

At operation S26, a housing 20 may be formed by tertiary-CNC-processing the injection frame assembly 250. The tertiary CNC processing may include a processing process of removing unnecessary portions of the injection frame assembly 250 or forming a passageway part 21 or the like.

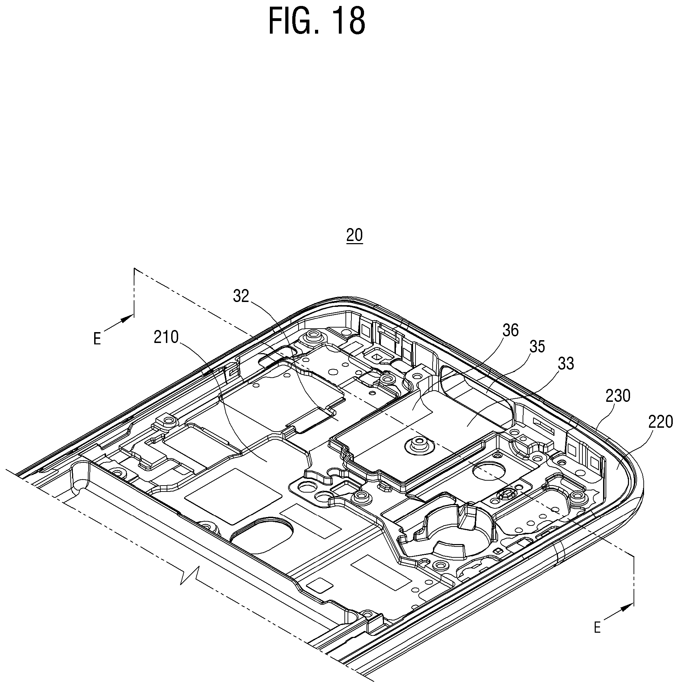

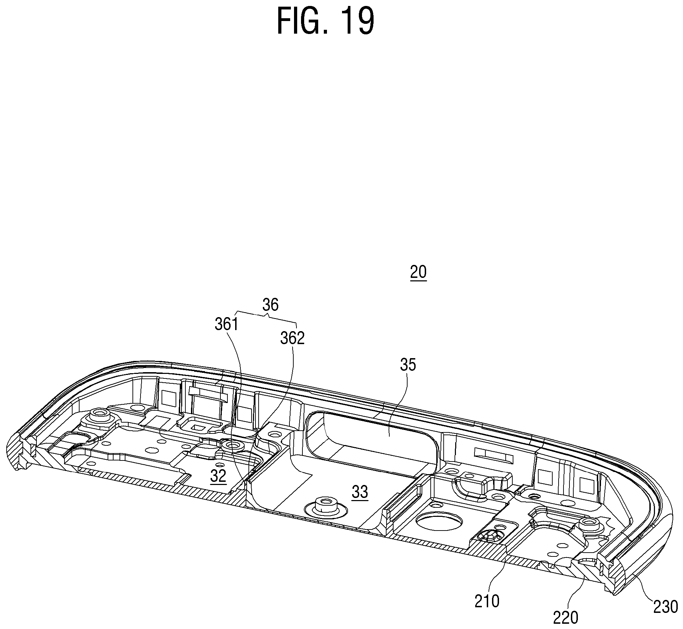

FIG. 18 is a view showing a housing 20 according to an embodiment of the disclosure, and FIG. 19 is a cross-sectional view taken along line E-E of FIG. 18 according to an embodiment of the disclosure.

Referring to FIGS. 18 and 19, the internal frame 210 may include an internal frame 210 made of a casting material, an external frame 230 made of a rolled or extruded material, and a support frame 220 made of an injection material for coupling and supporting the internal frame 210 and the external frame 230. The housing 20 may include a third space 32 accommodating components therein, and a fourth space 33 in which, for example, a slide camera capable of sliding and withdrawing to the outside is arranged through a passageway part 35, for example, a camera inlet.

The housing 20 may include an isolation wall 36 that isolates the third space 32 and the fourth space 33. The isolation wall 36 may include a first isolation wall 361 of a casting material formed when the internal frame 210 is casted and a second isolation wall 362 of an injection material formed when the support frame 220 is insert-injected. As described above, by coupling or bonding the second isolation wall 362 of the injection material to the first isolation wall 361 of the casting material, water introduced into the fourth space33 may be prevented from leaking to the third space32 through pores of the first isolation wall 361.

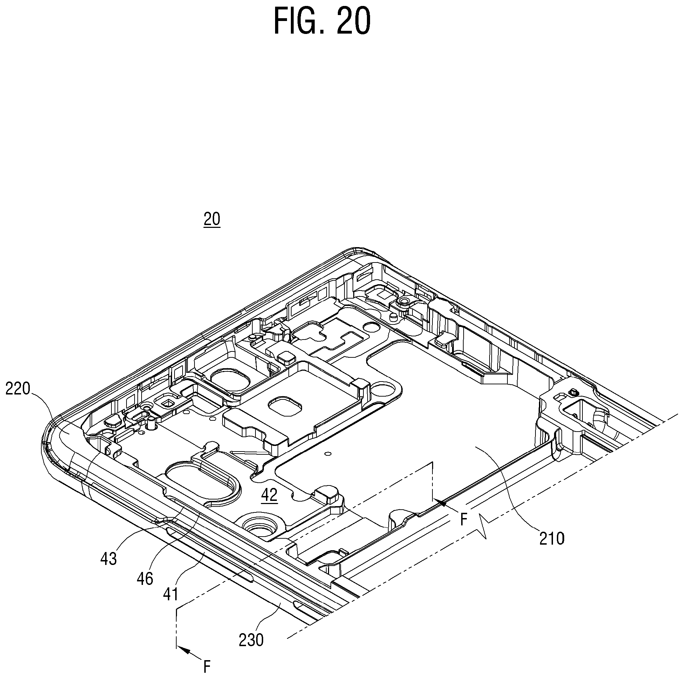

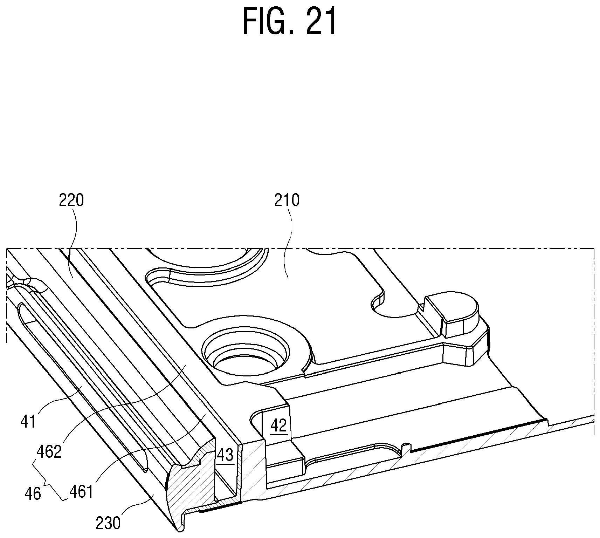

FIG. 20 is a view showing a housing 20 according to further an embodiment of the disclosure, and FIG. 21 is a cross-sectional view taken along line F-F of FIG. 20 according to an embodiment of the disclosure.

Referring to FIGS. 20 and 21, the housing 20 may include a third space 42 accommodating components therein and a fourth space 43 in which a side key is arranged.

The housing 20 may include an isolation wall 46 that isolates the third space 42 and the fourth space 43. The isolation wall 46 may include a first isolation wall 461 of a casting material formed when the internal frame 210 is casted and a second isolation wall 462 of an injection material formed when the support frame 220 is insert-injected. As described above, by coupling or bonding the second isolation wall 462 of the injection material to the first isolation wall 461 of the casting material, water introduced into the fourth space 43 through a passageway part 41, for example, a side key (button) insertion hole, may be prevented from leaking to the third space42 through pores of the first isolation wall 461.

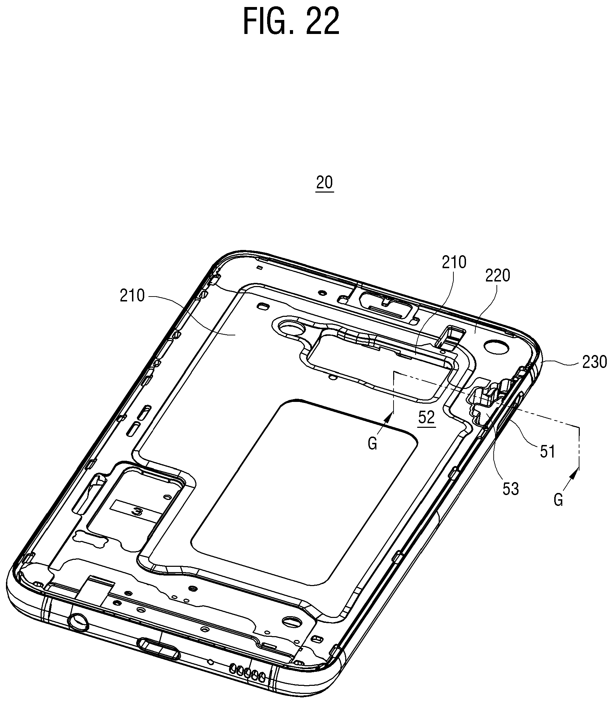

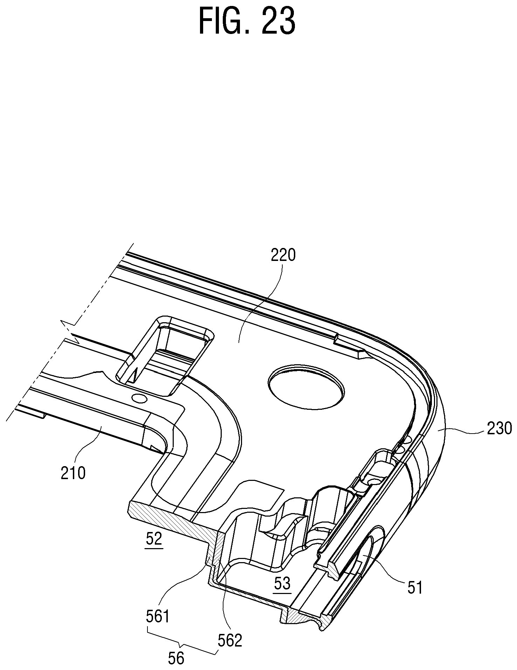

FIG. 22 is a view showing a housing 20 according to still an embodiment of the disclosure, and FIG. 23 is a cross-sectional view taken along line G-G of FIG. 22 according to an embodiment of the disclosure.

Referring to FIGS. 22 and 23, the housing 20 may include a third space 52 accommodating components therein and a fourth space 53 in which a fingerprint recognition key is arranged.

The housing 20 may include an isolation wall 56 that isolates the third space 52 and the fourth space 53. The isolation wall 56 may include a first isolation wall 561 of a casting material formed when the internal frame 210 is casted and a second isolation wall 562 of an injection material formed when the support frame 220 is insert-injected. In this way, by coupling or bonding the second isolation wall 562 of the injection material to the first isolation wall 561 of the casting material, water introduced into the fourth space 53 through a passageway part 51, for example, a key insertion hole, may be prevented from leaking to the third space 52 through pores of the first isolation wall 561.

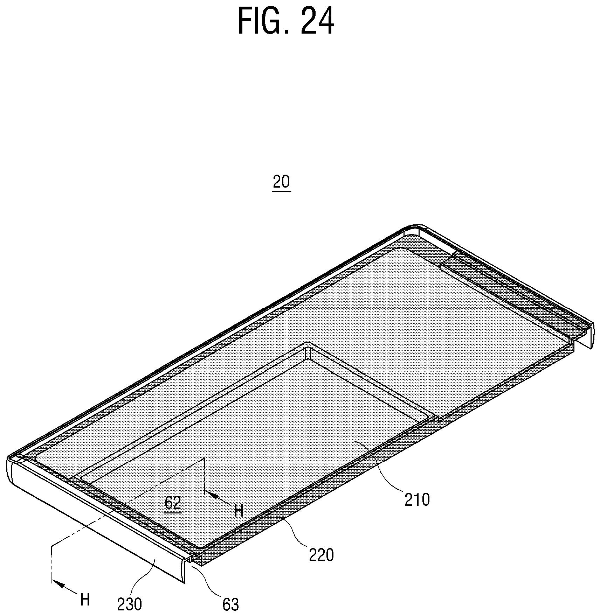

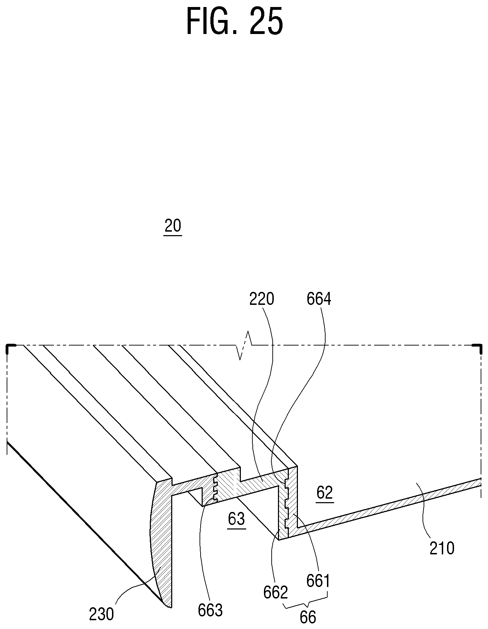

FIG. 24 is a view showing a housing 20 according to an embodiment of the disclosure, and FIG. 25 is a cross-sectional view taken along line H-H of FIG. 24 according to an embodiment of the disclosure.

Referring to FIGS. 24 and 25, the housing 20 may include a third space 62 accommodating components therein and a fourth space 63 in which a rail of a rollable display is arranged.

The fourth space63 may be formed of an internal frame 210 made of a metal casting material, an external frame 230 made of a metal rolled material or extruded material, and a support frame 220 made of an injection material connecting the internal frame 210 and the external frame 230. The support frame 220 and the external frame 230 may be coupled or joined by a first uneven portion 663.

The housing 20 may include an isolation wall 66 that isolates the third space 62 and the fourth space 63. The isolation wall 66 may include a first isolation wall 661 of a casting material formed when the internal frame 210 is casted and a second isolation wall 662 of an injection material formed when the support frame 220 is insert-injected. In this way, by coupling or bonding the second isolation wall 662 of the injection material to the first isolation wall 661 of the casting material, water introduced into the fourth space 63 through a passageway part 61, for example, a rail insertion hole, may be prevented from leaking to the third space 62 through pores of the first isolation wall 661. The first isolation wall 661 and the second isolation wall 662 may be coupled or joined by, for example, a second uneven portion 664.

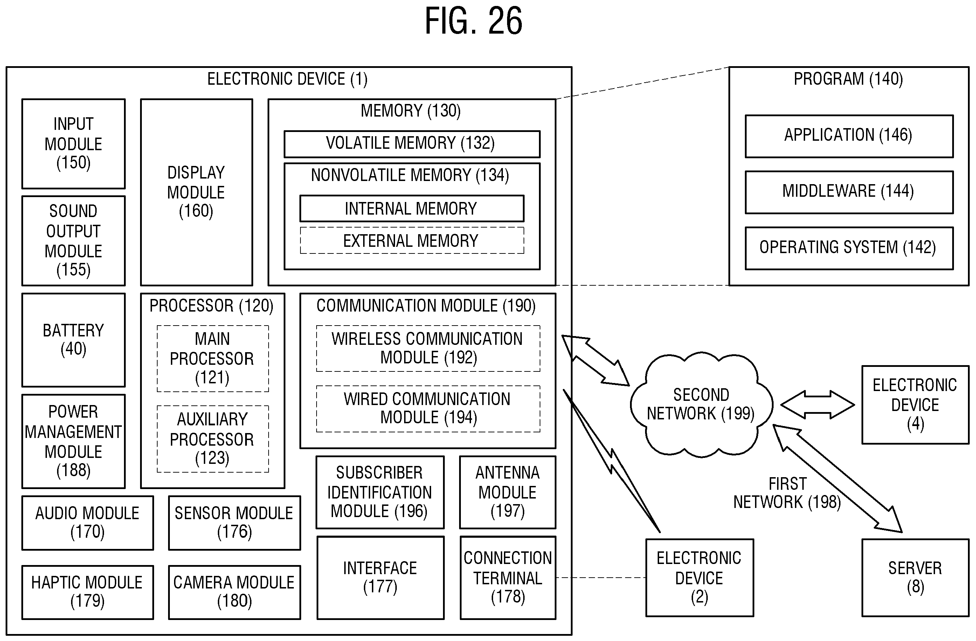

FIG. 26 is a block diagram of an electronic device 1 in a network environment according to an embodiment of the disclosure. Referring to FIG. 26, in the network environment, the electronic device 1 may communicate with an electronic device 2 through a first network 198 (e.g., short-range wireless communication network) or with at least one of an electronic device 4 or a server 8 through a second network 199 (e.g., a long-range wireless communication network). According to an embodiment, the electronic device 1 may communicate with the electronic device 4 through the server 8. According to an embodiment, the electronic device 1 may include a processor 120, a memory 130, an input module 150, a sound output module 155, a display module 160, an audio module 170, a sensor module 176, an interface 177, a connection terminal 178, a haptic module 179, a camera module 180, a power management module 188, a battery 40, a communication module 190, a subscriber identification module 196, or an antenna module 197. In an embodiment, at least one (e.g., the connection terminal 178) of these components may be omitted from the electronic device 1, or one or more other components may be added in the electronic device 1. In an embodiment, some (e.g., the sensor module 176, the camera module 180, or the antenna module 197) of these components may be integrated into one component (e.g., the display module 160).

The processor 120 may execute, for example, a software (e.g., a program 140) to control at least one other component (e.g., a hardware or software component) of the electronic device 1 connected to the processor 120, and may perform various data processing or operations. According to an embodiment, as at least part of data processing or operations, the processor 120 may store commands or data received from other components (e.g., the sensor module 176 or the communication module 190) in a volatile memory 132, process commands or data stored in the volatile memory 132, and store resulting data in a nonvolatile memory 134. According to an embodiment, the processor 120 may include a main processor 121 (e.g., a central processing unit or an application processor) or an auxiliary processor 123 (e.g., a graphic processing unit, a neural processing unit (NPU), an image signal processor, a sensor hub processor, or a communication processor) that may be operated independently or together with the main processor. For example, when the electronic device 1 includes the main processor 121 and the auxiliary processor 123, the auxiliary processor 123 may use lower power than the main processor 121 or may be set to be specialized in a designated function. The auxiliary processor 123 may be implemented separately from the main processor 121 or as a part thereof.

The auxiliary processor 123 may control at least some of functions or states related to at least one (e.g., the display module 160, the sensor module 176, or the communication module 190) of the components of the electronic device 1 instead of the main processor 121 while the main processor 121 is in an inactive state (e.g., a sleep state) or together with the main processor 121while the main processor 121 is in an active state (e.g., an application execution state). According to an embodiment, the auxiliary processor 123 (e.g., the image signal processor or the communication processor) may be implemented as a part of another functionally related component (e.g., the camera module 180 or the communication module 190). According to an embodiment, the auxiliary processor 123 (e.g., the neural network processing device) may include a hardware structure specialized in processing an artificial intelligence model. The artificial intelligence model may be created through machine learning. Such learning may be performed, for example, in the electronic device 1 itself where the artificial intelligence model is performed, or may be performed through a separate server (e.g., the server 8). An algorithm for such learning may include, for example, supervised learning, unsupervised learning, semi-supervised learning, or reinforcement learning, but is not limited to the examples described above. The artificial intelligence model may include a plurality of artificial neural network layers. An artificial neural network may be deep neural network (DNN), convolutional neural network (CNN), recurrent neural network (RNN), restricted boltzmann machines (RBM), deep neural network (DBN), bidirectional recurrent deep neural network(BRDNN), deep Q-networks, or a combination of more than two thereof, but is not limited to the examples described above. In addition to the hardware structure, the artificial intelligence model may additionally or alternatively include a software structure.

The memory 130 may store various data used by at least one component (e.g., the processor 120 or the sensor module 176) of the electronic device 1. The data may include, for example, the software (e.g., the program 140) and input data or output data for commands related thereto. The memory 130 may include the volatile memory 132 or the nonvolatile memory 134.

The program 140 may be stored as a software in the memory 130, and may include, for example, an operating system 142, a middleware 144, or an application 146.

The input module 150 may receive commands or data to be used in components (e.g., the processor 120) of the electronic device 1 from the outside (e.g., a user) of the electronic device 1. The input module 150 may include, for example, a microphone, a mouse, a keyboard, a key (e.g., a button), or an input pen 3 (e.g., a stylus pen).

The sound output module 155 may output a sound signal to the outside of the electronic device 1. The sound output module 155 may include, for example, a speaker or a receiver. The speaker may be used for general purposes such as multimedia playback or recording playback. The receiver may be used to receive incoming calls. According to an embodiment, the receiver may be implemented separately from or as a part of the speaker.

The display module 160 may visually provide information to the outside (e.g., the user) of the electronic device 1. The display module 160 may include, for example, a display, a hologram device, or a projector and a control circuit for controlling the corresponding device. According to an embodiment, the display module 160 may include a touch sensor set to sense a touch or a pressure sensor set to measure an intensity of force generated by the touch.

The audio module 170 may convert sound into an electrical signal or vice versa. According to an embodiment, the audio module 170 may acquire sound through the input module 150, or output sound through the sound output module 155 or an external electronic device (e.g., the electronic device 2) (e.g., the speaker or headphone) directly or wirelessly connected to the electronic device 1.

The sensor module 176 may detect an operating state (e.g., power or temperature) of the electronic device 1 or an external environmental state (e.g., user state) and generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared sensor, a biometric sensor, a temperature sensor, a humidity sensor, or an illuminance sensor.

The interface 177 may support one or more designated protocols that may be used for the electronic device 1 to be directly or wirelessly connected with an external electronic device (e.g., the electronic device 2). According to an embodiment, the interface 177 may include, for example, a high definition multimedia interface (HDMI), a universal serial bus (USB) interface, an SD card interface, or an audio interface.

The connection terminal 178 may include a connector through which the electronic device 1 may be physically connected to an external electronic device (e.g., the electronic device 2). According to an embodiment, the connection terminal 178 may include, for example, an HDMI connector, a USB connector, a secure digital (SD) card connector, or an audio connector (e.g., a headphone connector).

The haptic module 179 may convert an electrical signal into a mechanical stimulus (e.g., vibration or movement) or an electrical stimulus that the user may recognize through tactile or kinesthetic senses. According to an embodiment, the haptic module 179 may include, for example, a motor, a piezoelectric element, or an electrical stimulation device.

The camera module 180 may capture a still image and a moving image. According to an embodiment, the camera module 180 may include one or more lenses, one or more image sensors, one or more image signal processors, or one or more flashes.

The power management module 188 may manage power supplied to the electronic device 1. According to an embodiment, the power management module 188 may be implemented as, for example, at least part of a power management integrated circuit (PMIC).

The battery 40 may supply power to at least one component of the electronic device 1. According to an embodiment, the battery 40 may include, for example, an unrechargeable primary battery, a rechargeable secondary battery, or a fuel cell.

The communication module 190 may support establishment of a direct (e.g., wired) communication channel or wireless communication channel between the electronic device 1 and the external electronic device (e.g., the electronic device 2, the electronic device 4, or the server 8), and communication execution through the established communication channel. The communication module 190 may include one or more communication processors, which operate independently of the processor 120 (e.g., the application processor) and which support direct (e.g., wired) communication or wireless communication. According to an embodiment, the communication module 190 may include a wireless communication module 192 (e.g., a cellular communication module, a short-range wireless communication module, a global navigation satellite system (GNSS) communication module, a wired communication module 194 (e.g., a local area network (LAN), or a power line communication module). The corresponding communication module among these communication modules may communicate with the external electronic device 4 through a first network 198 (e.g., a short-range communication network, such as Bluetooth, wireless fidelity (WiFi) direct, or infrared data association (IrDA)),or a second network 199 (e.g., a long-range communication network, such as legacy cellular network, fifth generation (5G) network, next-generation communication network, Internet, or computer network (e.g., LAN or wide area network (WAN))). These types of communication modules may be integrated into one component (e.g., a single chip), or may be implemented as multiple separate components (e.g., multiple chips). The wireless communication module 192 may verify or authenticate the electronic device 1 within a communication network such as the first network 198 or the second network 199 using subscriber information (e.g., international mobile subscriber identifier (IMSI))stored in the subscriber identification module 196.

The wireless communication module 192 may support 5G network and next-generation communication technologies after the fourth generation (4G) network, such as new radio (NR)access technology. The NR access technology may support highspeed transmission of largecapacity data (e.g., advanced mobile broadband (eMBB)), terminal power minimization and mass machine type communication (mMTC), or ultra-reliable and low-latency communication (URLLC). The wireless communication module 192 may support, for example, a high frequency band (e.g., mmWave band) to achieve a high data transmission rate. The wireless communication module 192 has various technologies for securing performances in a high frequency band, such as, for example, beamforming, massive multiple-input and multiple-output (MIMO), full-dimensional MIMO (FD-MIMO), array antenna, analog beam-forming, or large scale antenna. The wireless communication module 192 may support various requirements defined in the electronic device 1, the external electronic device (e.g., the electronic device 4), or the network system (e.g., the second network 199). According to an embodiment, the wireless communication module 192 may support peak data rate (e.g., 20 Gbps or more) for realizing eMBB, loss coverage (e.g., 164 dB or less) for realizing mMTC, or U-plane latency (e.g., downlink (DL) and uplink (UL) of 0.5 ms or less, or round trip of 1 ms or less)for realizing URLLC.

The antenna module 197 may transmit a signal or power to the outside (e.g., the external electronic devices) or receive the signal or power from the outside. According to an embodiment, the antenna module 197 may include an antenna radiator arranged to integrally extend from the internal frame 210 made of the conductive material constituting the housing 20. According to an embodiment, the antenna module 197 may include an antenna including a radiator made of a conductor or a conductive pattern formed on a substrate (e.g., a printed circuit board (PCB)). According to an embodiment, the antenna module 197 may include a plurality of antennas (e.g., an array antenna). In this case, at least one antenna suitable for a communication scheme used in the communication network such as the first network 198 or the second network 199 may be selected from the plurality of antennas by, for example, the communication module 190. The signal or power may be transmitted or received between the communication module 190 and the external electronic device through the selected at least one antenna. According to an embodiment, component(s)(e.g., a radio frequency integrated circuit (RFIC))other than the radiator may be additionally formed as a part of the antenna module 197. According to an embodiment, the antenna module 197 may form an mmWave antenna module. According to an embodiment, the mmWave antenna module may include a printed circuit board, an RFIC arranged on or adjacent to one surface (e.g., a bottom surface) of the printed circuit board and capable of supporting a specified high frequency band (e.g., mmWave band), and a plurality of antennas (e.g., the array antenna)arranged on or adjacent to the other surface (e.g., an upper surface or a side surface)of the printed circuit board and capable of transmitting and receiving a signal of the specified high frequency band.

At least some of the components as described above may be connected to and exchange signals (e.g., commands or data) between each other through a communication method between peripheral devices (e.g., a bus, a general purpose input and output (GPIO), a serial peripheral interface (SPI), or a mobile industrial processor interface (MIPI)).

According to an embodiment, the commands or data may be transmitted or received between the electronic device 1 and the external electronic device 4 through the server 8 connected to the second network 199. Each of the external electronic devices 2 or 4 may be a device of type equal to or different from the electronic device 1. According to an embodiment, all or some of operations executed in the electronic device 1 may be executed in one or more external electronic devices among the external electronic devices 2, 4, and 8. For example, if electronic device 1 needs to perform a function or service automatically or in response to a request from a user or other device, the electronic device 1 may request one or more external electronic devices to perform at least part of the function or service instead of or in addition to executing the function or service by itself. The one or more external electronic devices receiving the request may execute the at least part of the requested function or service, or an additional function or service related to the request, and transmit a result of the execution to the electronic device 1. The electronic device 1 may process the result as it is or additionally in order to provide as at least part of the response to the request. To this end, for example, cloud computing technology, distributed computing technology, mobile edge computing (MEC)technology, or client-server computing technology may be used. The electronic device 1 may provide an ultra-low delay service using, for example, the distributed computing technology or the mobile edge computing technology. In an embodiment, the external electronic device 4 may include an Internet of Things (IoT) device. The server 8 may be an intelligent server using the machine learning and/or neural network. According to an embodiment, the external electronic device 4 or the server 8 may be included in the second network 199. The electronic device 1 may be applied to an intelligent service (e.g., a smart home, a smart city, a smart car, or a healthcare) based on 5G communication technology and IoT-related technology.

## Claims

1. A mobile electronic device comprising:
a first component;
a second component;
a first space (22) arranged to accommodate the first component;
a second space (23) arranged adjacent to the first space (22) to accommodate the second component and communicate with outside of the mobile electronic device in a first direction, and having a side opened in a second direction perpendicular to the first direction;
a housing (20) comprising an isolation part (26) for isolating the first space (22) and the second space (23); and
a sealing member (27) arranged on the opened side of the second space (23),
**characterized in that**,
the isolation part (26) comprises a first isolation part (261) comprising a metal material formed by casting and a second isolation part (262) coupled to the first isolation part (261) comprising an injection material formed by injection.

2. The mobile electronic device of claim 1, wherein the second isolation part is arranged in the second space (23) formed by an internal frame (210).

3. The mobile electronic device of claim 1, wherein the second isolation part (262) is formed to be bent and extended to a bottom of the second space (23).

4. The mobile electronic device of claim 1, wherein the housing (20) comprises:
an internal frame (210) formed of the metal material to form the first space (22) and the second space (23); and
a support frame (220) formed of the injection material to support the internal frame (210).

5. The mobile electronic device of claim 4,
wherein the metal material comprises a first metal material, and
wherein the housing (20) further comprises an external frame (230) coupled to the internal frame (210) to form an appearance of the mobile electronic device, and formed of a second metal material different from the first metal material.

6. The mobile electronic device of claim 5,
wherein the first metal material comprises a casting material, and
wherein the second metal material comprises one of an extrusion material, a rolled material, a drawing material, a metal injection molding, MIM, material, a three-dimensional 3D printing material, or a press material.

7. The mobile electronic device of claim 5,
wherein the first metal material comprises at least one of aluminum, Al, magnesium, Mg, zinc, Zn, copper, Cu, or an alloy thereof, and
wherein the second metal material comprises at least one of Al, stainless steel, SUS, titanium, Ti, Mg or an alloy thereof.

8. The mobile electronic device of claim 5, wherein the injection material comprises a thermoplastic resin and an inorganic substance.

9. The mobile electronic device of claim 5, wherein the external frame (230) comprises a passageway part (21) arranged to connect the second space (23) with the outside of the mobile electronic device.

10. The mobile electronic device of claim 5, wherein the support frame (220) is interposed between the internal frame (210) and the external frame (230).

11. The mobile electronic device of claim 5, wherein the housing (20) further comprises a waterprooftape attached between the internal frame (210) and the external frame (230).

12. The mobile electronic device of claim 1,
wherein the first component comprises a battery (40),
wherein the second component comprises an input pen (3), and
wherein the second space (23) comprises a pen accommodation part configured to accommodate the input pen (3).

13. The mobile electronic device of claim 1, wherein the second component comprises at least one of a side key, a fingerprint recognition key, or a slide camera.

14. The mobile electronic device of claim 1,
wherein the first isolation part (261) comprises pores (2611) or cracks, and
wherein the pores (2611) or cracks of the first isolation part (261) are filled with the injection material of the second isolation part (262).

15. A method of manufacturing a mobile electronic device, including a first component; a second component; a first space (22) arranged to accommodate the first component; a second space (23) arranged adjacent to the first space (22) to accommodate the second component and communicate with outside of the mobile electronic device in a first direction, and having a side opened in a second direction perpendicular to the first direction; a housing (20) comprising an isolation part (26) for isolating the first space (22) and the second space (23); and a sealing member (27) arranged on the opened side of the second space (23), the isolation part (26) comprises a first isolation part (261) and a second isolation part (262) coupled to the first isolation part (261), the method comprising:
forming the first isolation part (261) comprising a metal material by casting, and
forming the second isolation part (262) comprising an injection material by injection.

## Patentansprüche

1. Mobiles elektronisches Gerät, umfassend:
eine erste Komponente;
eine zweite Komponente;
einen ersten Raum (22), der angeordnet ist, um die erste Komponente aufzunehmen;
einen zweiten Raum (23), der benachbart zum ersten Raum (22) angeordnet ist, um die zweite Komponente aufzunehmen und in einer ersten Richtung mit der Außenseite des mobilen elektronischen Geräts in Verbindung zu stehen, und der eine in einer zweiten Richtung, senkrecht zur ersten Richtung, geöffnete Seite aufweist;
ein Gehäuse (20), umfassend einen Trennteil (26) zum Trennen des ersten Raums (22) und des zweiten Raums (23); und
ein Dichtelement (27), das an der geöffneten Seite des zweiten Raums (23) angeordnet ist,
**dadurch gekennzeichnet, dass**
der Trennteil (26) einen ersten Trennteil (261), der ein durch Gießen gebildetes Metallmaterial umfasst, und einen mit dem ersten Trennteil (261) verbundenen zweiten Trennteil (262), der ein durch Spritzen gebildetes Spritzmaterial umfasst, aufweist.

2. Mobiles elektronisches Gerät nach Anspruch 1, wobei der zweite Trennteil in dem zweiten Raum (23) angeordnet ist, der durch einen Innenrahmen (210) gebildet ist.

3. Mobiles elektronisches Gerät nach Anspruch 1, wobei der zweite Trennteil (262) ausgebildet ist, um zu einem Boden des zweiten Raums (23) gebogen und erstreckt zu sein.

4. Mobiles elektronisches Gerät nach Anspruch 1, wobei das Gehäuse (20) umfasst:
einen Innenrahmen (210), der aus dem Metallmaterial gebildet ist, um den ersten Raum (22) und den zweiten Raum (23) zu bilden; und
einen Stützrahmen (220), der aus dem Spritzmaterial gebildet ist, um den Innenrahmen (210) zu stützen.

5. Mobiles elektronisches Gerät nach Anspruch 4,
wobei das Metallmaterial ein erstes Metallmaterial umfasst, und
wobei das Gehäuse (20) ferner einen Außenrahmen (230) umfasst, der mit dem Innenrahmen (210) verbunden ist, um ein Erscheinungsbild des mobilen elektronischen Geräts zu bilden, und der aus einem zweiten Metallmaterial gebildet ist, das sich von dem ersten Metallmaterial unterscheidet.

6. Mobiles elektronisches Gerät nach Anspruch 5,
wobei das erste Metallmaterial ein Gussmaterial umfasst, und
wobei das zweite Metallmaterial eines aus einem Strangpressmaterial, einem Walzmaterial, einem Ziehmaterial, einem Metallpulverspritzguss- (MIM-) Material, einem Dreidimensionalen- (3D-) Druckmaterial oder einem Pressmaterial umfasst.

7. Mobiles elektronisches Gerät nach Anspruch 5,
wobei das erste Metallmaterial mindestens eines aus Aluminium (Al), Magnesium (Mg), Zink (Zn), Kupfer (Cu) oder einer Legierung davon umfasst, und
wobei das zweite Metallmaterial mindestens eines aus Al, rostfreiem Stahl (SUS), Titan (Ti), Mg oder einer Legierung davon umfasst.

8. Mobiles elektronisches Gerät nach Anspruch 5, wobei das Spritzmaterial ein thermoplastisches Harz und einen anorganischen Stoff umfasst.

9. Mobiles elektronisches Gerät nach Anspruch 5, wobei der Außenrahmen (230) einen Durchgangsteil (21) umfasst, der angeordnet ist, um den zweiten Raum (23) mit der Außenseite des mobilen elektronischen Geräts zu verbinden.

10. Mobiles elektronisches Gerät nach Anspruch 5, wobei der Stützrahmen (220) zwischen dem Innenrahmen (210) und dem Außenrahmen (230) angeordnet ist.

11. Mobiles elektronisches Gerät nach Anspruch 5, wobei das Gehäuse (20) ferner ein zwischen dem Innenrahmen (210) und dem Außenrahmen (230) angebrachtes wasserdichtes Klebeband umfasst.

12. Mobiles elektronisches Gerät nach Anspruch 1,
wobei die erste Komponente eine Batterie (40) umfasst,
wobei die zweite Komponente einen Eingabestift (3) umfasst, und
wobei der zweite Raum (23) einen Stiftaufnahmeteil umfasst, der konfiguriert ist, um den Eingabestift (3) aufzunehmen.

13. Mobiles elektronisches Gerät nach Anspruch 1, wobei die zweite Komponente mindestens eines aus einer Seitentaste, einer Fingerabdruckerkennungstaste oder einer Schiebekamera umfasst.

14. Mobiles elektronisches Gerät nach Anspruch 1,
wobei der erste Trennteil (261) Poren (2611) oder Risse umfasst, und
wobei die Poren (2611) oder Risse des ersten Trennteils (261) mit dem Spritzmaterial des zweiten Trennteils (262) ausgefüllt sind.

15. Verfahren zur Herstellung eines mobilen elektronischen Geräts, das eine erste Komponente; eine zweite Komponente; einen ersten Raum (22), der angeordnet ist, um die erste Komponente aufzunehmen; einen zweiten Raum (23), der benachbart zum ersten Raum (22) angeordnet ist, um die zweite Komponente aufzunehmen und in einer ersten Richtung mit der Außenseite des mobilen elektronischen Geräts in Verbindung zu stehen, und der eine in einer zweiten Richtung, senkrecht zur ersten Richtung, geöffnete Seite aufweist; ein Gehäuse (20), umfassend einen Trennteil (26) zum Trennen des ersten Raums (22) und des zweiten Raums (23); und ein Dichtelement (27), das an der geöffneten Seite des zweiten Raums (23) angeordnet ist, umfasst, wobei der Trennteil (26) einen ersten Trennteil (261) und einen mit dem ersten Trennteil (261) verbundenen, zweiten Trennteil (262) umfasst, wobei das Verfahren umfasst:
Ausbilden des ersten Trennteils (261), umfassend ein Metallmaterial durch Gießen, und
Ausbilden des zweiten Trennteils (262), umfassend ein Spritzmaterial durch Spritzen.

## Revendications

1. Équipement électronique mobile, comprenant :
un premier composant ;
un second composant ;
un premier espace (22) disposé pour accueillir le premier composant ;
un second espace (23) disposé pour être adjacent au premier espace (22) pour accueillir le second composant et communiquer avec un extérieur de l'équipement électronique mobile dans une première direction, et ayant un côté ouvert dans une seconde direction perpendiculaire à la première direction ;
un boîtier (20) comprenant une portion d'isolation (26) pour isoler le premier espace (22) et le second espace (23) ; et
un élément d'étanchéité (27) disposé sur le côté ouvert du second espace (23),
**caractérisé en ce que**,
la portion d'isolation (26) comprend une première portion d'isolation (261) comprenant un matériau métallique formé par moulage et une seconde portion d'isolation (262) couplée à la première portion d'isolation (261) comprenant un matériau d'injection formé par injection.

2. Équipement électronique mobile selon la revendication 1, dans lequel la seconde portion d'isolation est disposée dans le second espace (23) formé par un cadre interne (210).

3. Équipement électronique mobile selon la revendication 1, dans lequel la seconde portion d'isolation (262) est formée pour être pliée et étendue jusqu'au fond du second espace (23).

4. Équipement électronique mobile selon la revendication 1, dans lequel le boîtier (20) comprend :
un cadre interne (210) formé du matériau métallique pour former le premier espace (22) et
le second espace (23) ; et
un cadre de support (220) formé du matériau d'injection pour soutenir le cadre interne (210).

5. Équipement électronique mobile selon la revendication 4,
dans lequel le matériau métallique comprend un premier matériau métallique, et
dans lequel le boîtier (20) comprend en outre un cadre externe (230) couplé au cadre interne (210) pour former un aspect de l'équipement électronique mobile, et formé d'un second matériau métallique différent du premier matériau métallique.

6. Équipement électronique mobile selon la revendication 5,
dans lequel le premier matériau métallique comprend un matériau de moulage, et
dans lequel le second matériau métallique comprend l'un parmi un matériau d'extrusion, un matériau laminé, un matériau étiré, un matériau de moulage par injection métallique, MIM, un matériau d'impression tridimensionnelle (3D), ou un matériau de pressage.

7. Équipement électronique mobile selon la revendication 5,
dans lequel le premier matériau métallique comprend au moins un parmi l'aluminium (Al), le magnésium (Mg), le zinc (Zn), le cuivre (Cu), ou un alliage de ceux-ci, et
dans lequel le second matériau métallique comprend au moins un parmi l'Al, l'acier inoxydable (SUS), le titane (Ti), le Mg ou un alliage de ceux-ci.

8. Équipement électronique mobile selon la revendication 5, dans lequel le matériau d'injection comprend une résine thermoplastique et une substance inorganique.

9. Équipement électronique mobile selon la revendication 5, dans lequel le cadre externe (230) comprend une portion de passage (21) disposée pour relier le second espace (23) à l'extérieur de l'équipement électronique mobile.

10. Équipement électronique mobile selon la revendication 5, dans lequel le cadre de support (220) est interposé entre le cadre interne (210) et le cadre externe (230).

11. Équipement électronique mobile selon la revendication 5, dans lequel le boîtier (20) comprend en outre un ruban imperméable fixé entre le cadre interne (210) et le cadre externe (230).

12. Équipement électronique mobile selon la revendication 1,
dans lequel le premier composant comprend une batterie (40),
dans lequel le second composant comprend un stylet d'entrée (3), et
dans lequel le second espace (23) comprend une portion d'accueil de stylet configurée pour accueillir le stylet d'entrée (3).

13. Équipement électronique mobile selon la revendication 1, dans lequel le second composant comprend au moins un parmi une touche latérale, une touche de reconnaissance d'empreinte digitale ou une caméra escamotable.

14. Équipement électronique mobile selon la revendication 1,
dans lequel la première portion d'isolation (261) comprend des pores (2611) ou des fissures, et
dans lequel les pores (2611) ou fissures de la première portion d'isolation (261) sont remplis du matériau d'injection de la seconde portion d'isolation (262).

15. Procédé de fabrication d'un équipement électronique mobile, comprenant un premier composant ; un second composant ; un premier espace (22) disposé pour accueillir le premier composant ; un second espace (23) disposé pour être adjacent au premier espace (22) pour accueillir le second composant et communiquer avec un extérieur de l'équipement électronique mobile dans une première direction, et ayant un côté ouvert dans une seconde direction perpendiculaire à la première direction ; un boîtier (20) comprenant une portion d'isolation (26) pour isoler le premier espace (22) et le second espace (23) ; et un élément d'étanchéité (27) disposé sur le côté ouvert du second espace (23), la portion d'isolation (26) comprenant une première portion d'isolation (261) et une seconde portion d'isolation (262) couplée à la première portion d'isolation (261), le procédé comprenant :
former la première portion d'isolation (261) comprenant un matériau métallique par moulage, et
former la seconde portion d'isolation (262) comprenant un matériau d'injection par injection.
